# EUROPEAN PATENT SPECIFICATION

(11) **EP 0 514 759 B1**
(45) Date of publication and mention of the grant of the patent: **05.08.1998**
(21) Application number: 92108091.7
(22) Date of filing: 13.05.1992
(51) Int. Cl.: G01R 33/16

(54) **Magnetic characteristics measuring apparatus**
Gerät zum Messen von magnetischen Charakteristika
Dispositif pour mesurer les charactéristiques magnétiques

(30) Priority: 24.05.1991 JP 120316/91
(43) Date of publication of application: 25.11.1992
(73) Proprietor: SEIKO INSTRUMENTS INC., Tokyo (JP)
(72) Inventor: Date, Muneyuki, Toyonaka-shi, Osaka (JP); Yamagishi, Akio, Minoo-shi, Osaka (JP)
(74) Representative: Fleuchaus, Leo, Dipl.-Ing.

(56) References cited:
- FR-A- 1 333 925
- MEASUREMENT TECHNIQUES vol. 31, no. 10 , October 1988 , NEW YORK US pages 1025 - 1027 L.V.LEBEDEVA EA. 'Metrological support to tests on weakly magnetic constructional materials'
- REVIEW OF SCIENTIFIC INSTRUMENTS. vol. 32, no. 1 , January 1961 , NEW YORK US pages 28 - 31 R.STEVENSON 'Measurement of magnetic susceptibility in very high pulsed fields'
- JOURNAL OF PHYSICS E. SCIENTIFIC INSTRUMENTS vol. 14, no. 4 , April 1981 , BRISTOL GB pages 453 - 456 M.MÜLLER &H.J.GÜNHERODT 'A pendulum balance for high temperatire magnetic susceptibility measurements'

## Description

### BACKGROUND OF THE INVENTION

The present invention relates to an apparatus for measuring magnetic characteristics of materials and more particularly to a magnetic characteristic measuring apparatus that can measure magnetic susceptibility of biomagnetic characteristics in very high sensitivity, and especially to an apparatus for measuring magnetic characteristics according to the preamble of claim 1.

Such an apparatus is for example known from Journal of Physics E. Scientific Instruments, vol. 14, no. 4 (1981), pages 453 - 456. In this document there is described a pendulum balance for high temperature susceptibility measurements wherein the off-set (from the equilibrium position) of a first beam of the pendulum loaded with a magnetic sample which is placed in a first external magnetic field is compensated by the fact that the second beam is loaded with a coil placed in a second external magnetic field and wherein a current is sent through said coil so as to balance the off-set of the first beam.

The intensity of said current is therefore a measure for the force required to balance the magnetic force on the sample and hence its magnetic susceptibility.

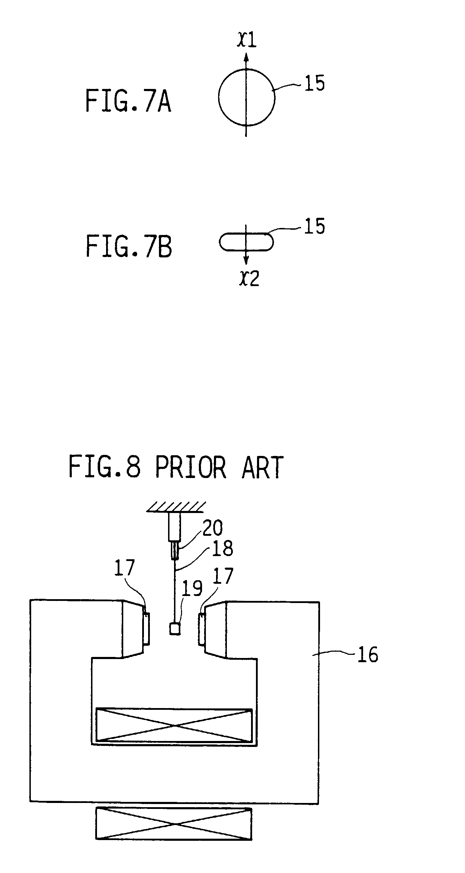

Various other methods and apparatuses for measuring magnetic characteristics have been proposed in the past. For example, the Faraday method is a method for measuring magnetic characteristics of a specimen from a magnitude of drive current applied to a dynamic system to dynamically balance to magnetic force that acts on the specimen placed within a certain magnetic field. A specimen oscillation method utilizes the fact that when a specimen mounted on a moving coil is oscillated in a certain magnetic field, current induced in the moving coil is influenced by magnetic characteristics of the specimen. An apparatus shown in Fig. 8 measures magnetic characteristics of a specimen 19 by applying an alternate magnetic field to the specimen 19 mounted at the tip of a quartz rod 18 to oscillate and by converting the oscillation by an electrostrictive element 20 mounted at the bottom of the quartz rod 18 to analyze the oscillation.

However, the aforementioned methods have a limit in the measuring sensitivity due to magnetic noise caused by ripple and switching noise of a power source since the certain magnetic field is applied during measuring. Moreover, it has been difficult to enhance the sensitivity of the measuring apparatus shown in Fig. 8 due to the influence of the magnetic noise as well as to the limit of characteristics of the electrostrictive element that converts amplitudes to electrical signals.

### SUMMARY OF THE INVENTION

It is an object of the present invention to provide an apparatus that allows to measure magnetic characteristics of a specimen in very high sensitivity by a relatively simple structure without being influenced by magnetic noise.

According to the present invention, a pulsed electromagnet is used as an electromagnet for generating a magnetic field that acts on a specimen to generate a pulsed or since wave-shaped one shot magnetic field or a periodic magnetic field for only a certain time period. The specimen is suspended from a simple dynamic oscillation system having a balancing mechanism comprising for example a balance, springs and pendulum. A displacement detecting means such as a laser micro-range finder that can detect amplitudes of the dynamic oscillation system in high resolution without contact is provided.

The specimen suspended from the dynamic oscillation system is placed at a position where the product of spatial magnetic field gradient (dH(t)/dz) and intensity of the magnetic field (H(t)) becomes the largest. The force F which the specimen receives at this time is:$\text{F =} \text{x} \text{H(t) dH(t)/dz}$ where, *x* is the magnetic susceptibility of the specimen.

Receiving this force, the dynamic oscillation system starts to oscillate and its oscillating amplitude is detected by the displacement detecting means. The magnetic field that effects the specimen is a one shot magnetic field and extinguishes after a predetermined time, and the oscillating amplitude may be enlarged by selecting the time during which the magnetic field is applied as the natural oscillation period of the dynamic oscillation system in a resonating relationship. The oscillating amplitude is detected in a free oscillating state after the extinction of the magnetic field, so that an influence of magnetic noise may be avoided. Magnetic susceptibility which is one of magnetic characteristics of the specimen may be found, without any noises, from the oscillating amplitude obtained and the intensity of magnetic field applied.

According to the apparatus of the present invention as structured above, such high sensitivity as in order of 10⁻¹² emu may be realized. Due to that, it allows to measure even very small specimens and may be applied in the biotechnological field where behaviors of bacteria, for example, are tracked from the aspect of magnetic characteristics. Furthermore, it allows to readily measure magnetic characteristics of a specimen having a magnetic anisotropy and the eliminate an influence of magnetic characteristics of the measuring apparatus itself on measured results.

### BRIEF DESCRIPTION OF THE DRAWINGS

Fig. 1 is a schematic drawing illustrating a basic structure of the present invention;
Figs. 2A and 2B are a diagram illustrating a waveform of a pulsed magnetic field applied to a specimen and a diagram illustrating an oscillating waveform of a balance, respectively;
Fig. 3 is a diagram illustrating a relationship between intensities of a magnetic field applied to Mohr's salt and amplitudes of a oscillating waveforms;
Fig. 4 is a diagram illustrating a relationship between intensities of a magnetic field applied to quartz and amplitudes of oscillating waveforms;
Fig. 5 is a diagram illustrating calibration lines for finding the magnetic susceptibility of a specimen from the oscillating amplitude;
Fig. 6 is a diagram illustrating a distribution of a magnetic field of a solenoid for generating a magnetic field;
Figs. 7A and 7B are a drawing illustrating the magnetic susceptibility in the direction along the disk surface of a red blood cell and a drawing illustrating the magnetic susceptibility in the direction vertical to the disk surface of a red blood cell, respectively; and
Fig. 8 is a schematic drawing illustrating a prior art magnetic characteristics measuring apparatus.

### DETAILED DESCRIPTION OF THE PREFERRED EMBODIMENT

Referring now to the drawings, preferred embodiments of the present invention will be explained.

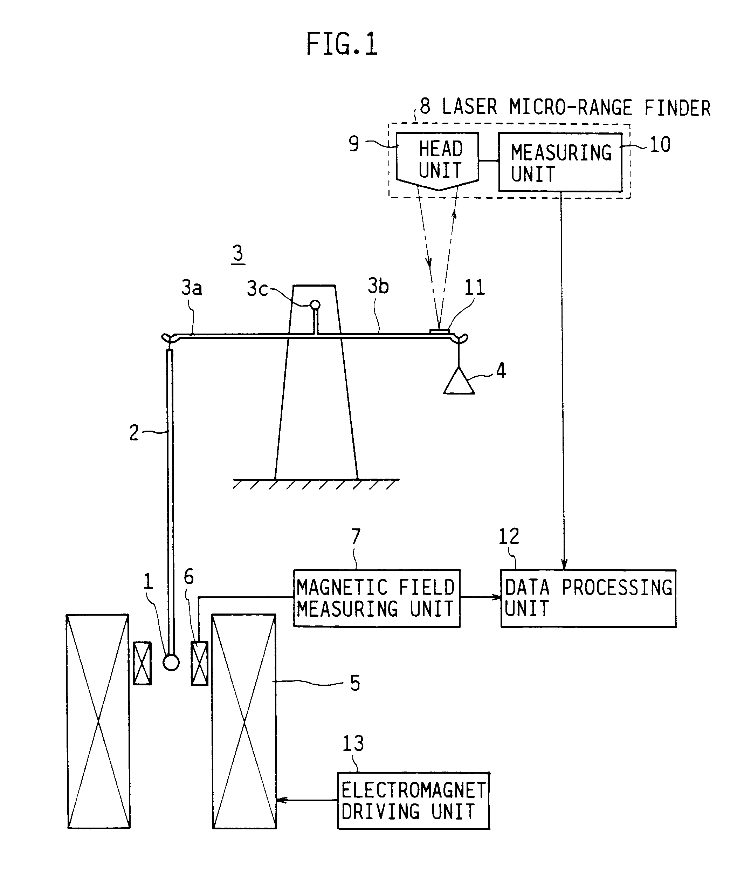

Fig. 1 is a schematic drawing illustrating a basic structure of the present invention. In the figure, a specimen 1 whose magnetic characteristics are to be measured is suspended from a beam 3a of a balance 3 through the intermediary of a supporting rod 2 made from quartz. A counter balance 4 for keeping the balance of the balance 3 about a supporting point 3c is suspended from another beam 3b of the balance 3. An electro-magnet 5 is a solenoid magnet that generates magnetic force for acting on the specimen 1 and is driven by an electromagnet driving unit 13. The specimen 1 is placed at a position where the product of the gradient of a magnetic field that is generated in the cavity and the intensity of the magnetic field becomes the largest. Then the intensity of the magnetic field applied to the specimen 1 is measured by a magnetic field sensor 6 for monitoring the magnetic field generated near the specimen 1 and by a magnetic field measuring unit 7 for measuring the magnetic field from the output of the magnetic field sensor 6. A laser micro-range finder 8 monitors unbalanced motion (oscillation) of the balance 3 when the magnetic force is applied to the specimen 1.

A laser beam is irradiated to a reflecting plate 11 mounted at the end portion of the beam 3b from a light emitting section of a head unit 9. Then its reflected light is detected by a light receiving section of the head unit 9 and very small amplitudes of the balance 3 during oscillating state are measured by a measuring unit 10. Then a data processing unit 12 finds magnetic characteristics of the specimen 1 from the intensity of the magnetic field and the oscillating amplitudes measured.

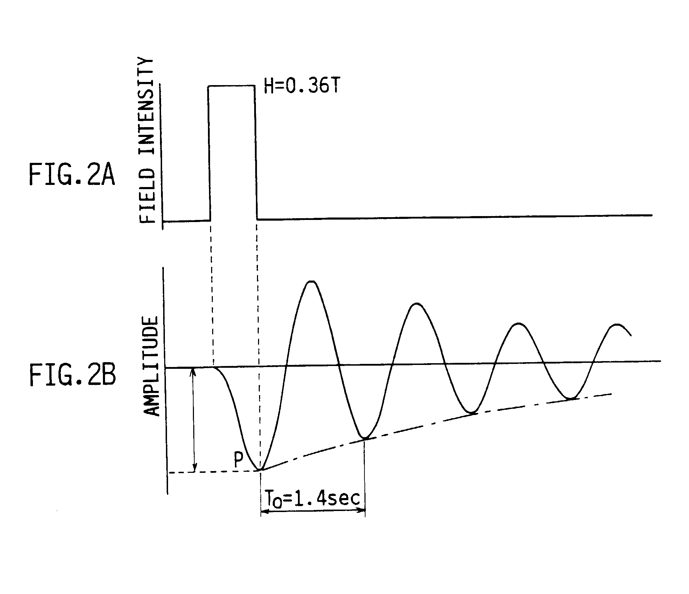

Figs. 2A and 2B illustrate an example when 20 mg of Mohr's salt (*x* 6.2 x 10⁻⁷ emu), a paramagnetic salt, used as a reference specimen in measuring magnetic susceptibility (*x*) which is one of magnetic characteristics was measured by the apparatus of the present invention.

Fig. 2A illustrates a pulsed magnetic field which is applied to the specimen and its intensity is H = 0.36 Tesla and its time duration is approximately 1 second. Fig. 2B illustrates an oscillating waveform of the balance 3 generated by the pulsed magnetic field and its oscillation period To = 1.4 sec. The oscillating waveform in Fig. 2B indicates a free oscillation accompanied by attenuation and its amplitude gradually decreases after the extinction of the pulsed magnetic field. An amplitude P immediately after the extinction of the pulsed magnetic field may be obtained by finding an envelope of the attenuating oscillating waveform. That is, the amplitude P may be obtained without being influenced by noise caused by the pulsed magnetic filed or any other background magnetic fields.

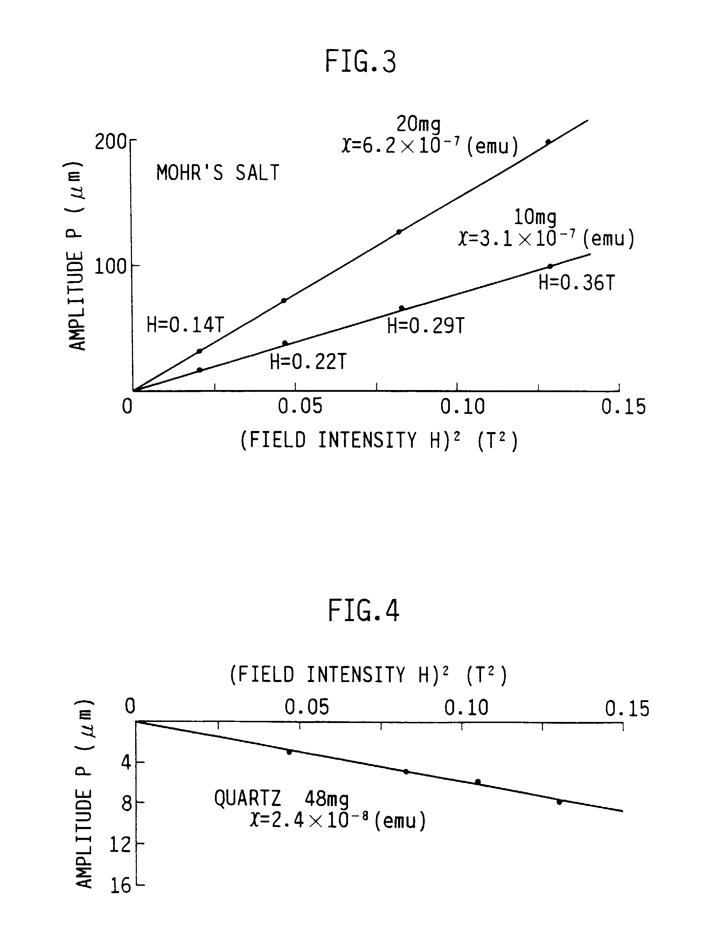

Fig. 3 illustrates results when the same measurements as in Fig. 2 are carried out changing the intensity of the magnetic field. From the figure, it can be seen that the amplitude P is proportional to the square of the intensity of the magnetic field. In the figure, measuring results for 10 mg Mohr's salt (*x* = 3.1 x 10⁻⁷ emu) are also shown. This graph also shows a good linear relationship between the amplitude P and the square of the intensity of the magnetic field.

Fig. 4 illustrates an example when 48 mg of quartz (*x* = 2.4 x 10⁻⁸ emu), a diamagnetic substance, was measured by the apparatus of the present invention. Although the direction of motion against the applied magnetic field is opposite to that in the case of paramagnetic substances, the relationship of the amplitude P and the square of the intensity of the magnetic field is linear similarly to the ones in Fig. 3.

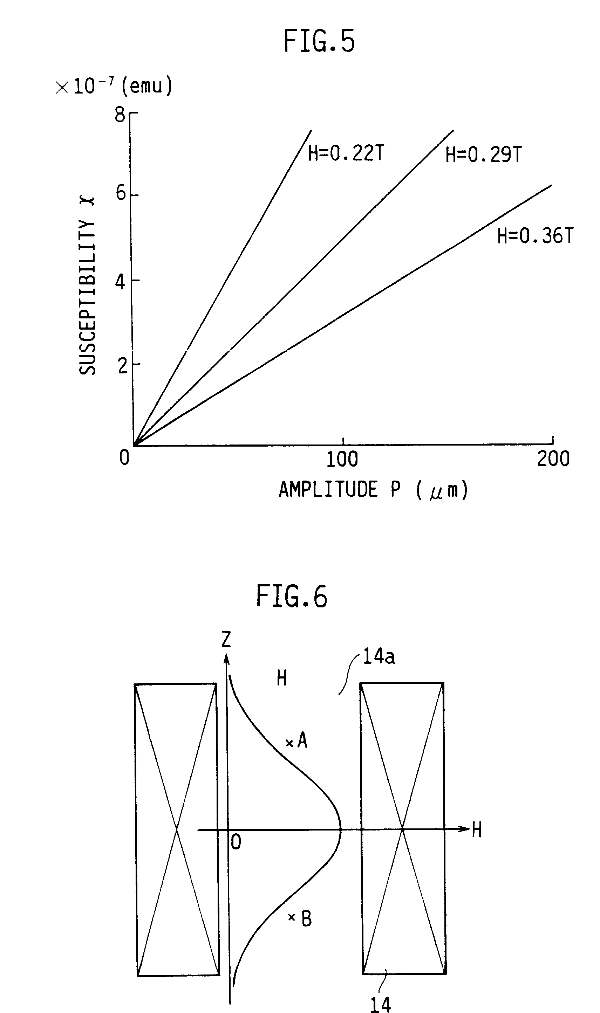

From the results of the measurement of specimens having known magnetic susceptibility like in Figs. 3 and 4, calibration lines as shown in Fig. 5 may be obtained. That is, a magnetic susceptibility of a specimen having unknown magnetic susceptibility may be found from an amplitude P when a predetermined magnetic field intensity is applied. It is also possible to calculate the magnetic susceptibility of an unknown specimen by automatic numerical operation by storing data which correspond to these calibration lines into a memory as a look-up table.

Next, description will be made on that the apparatus of the present invention is useful for measuring anisotropic susceptibility (Δ*x*) of a diamagnetic substance having a magnetic anisotropy and for eliminating fluctuation of measured values influenced by the magnetic susceptibility of a measuring apparatus itself.

Fig. 6 is a drawing illustrating distribution H of a magnetic field in a cavity 14a of a solenoid 14 for generating a magnetic field used in the apparatus of the present invention. As seen from the magnetic distribution H, there are two points of A and a in Fig. 6 where the product of the gradient and the intensity of the magnetic field becomes the largest in the cavity 14a.

Although quartz which is almost insusceptible to a magnetic field is used for the supporting rod for supporting the specimen, an influence of magnetic susceptibility of the quartz that effects on measured values cannot be ignored if the sensitivity of the apparatus is increased. In such case, the supporting rod made from quartz is elongated penetrating through the cavity 14a, not just to point A. At this time, magnetic forces having the same magnitude in the opposite directions act on the supporting rod at the upper and lower half parts of the cavity 14a, so that they offset each other and the influence of the magnetic susceptibility of the supporting rod may be eliminated, thereby enabling a very high sensitive measurement.

In another embodiment, a polyester fiber of 10 micrometer is used for the supporting rod for supporting the specimen. It is easier for the polyester fiber compared with the quartz to eliminate the influence of the magnetic susceptibility of the supporting rod itself, because of its uniformity and low volume.

Moreover, if specimens placed at point A and point B have the same magnetic characteristics, the magnetic forces act in opposite directions respectively and offset each other. On the other hand, when specimens having different magnetic characteristics (e.g. magnetic susceptibility) are placed at point A and point 3, the magnetic forces act on the dynamic oscillation system (balance) by a degree that corresponds to a difference of their magnetic susceptibilities. For example, a disk shaped red blood cell 15 which is a biological substance having diamagnetic characteristics as shown in Figs. 7A and 7B have a magnetic susceptibility *x* 1 along the surface of the disk (Fig. 7A) and a magnetic susceptibility *x* 2 in the direction vertical to the disk surface (Fig. 7B), which differ from each other, an anisotropic susceptibility of the red blood cell Δ*x* = *x*1 - *x*2 may be found by placing a red blood cell facing as shown in Fig. 7A at point A in Fig. 6 and by placing another red blood cell facing as shown in Fig. 7B at point B in Fig. 6.

When a magnetic susceptibility (*x*) of a specimen is to be measured, the measuring sensitivity of the apparatus of the present invention is proportional to the square of the intensity of the magnetic field applied, the time of the applied magnetic field and the oscillation period of the balance. Since the measuring sensitivity corresponds to the oscillating amplitude of the balance, the oscillating amplitude generated under a condition of predetermined time duration of application of a magnetic field and a predetermined oscillation period of the balance is proportional to the square of the intensity of the magnetic field. That is, to improve the measuring sensitivity, such means may be taken as to increase the intensity of the magnetic field, to increase measuring resolution of the oscillating amplitude and to enlarge the oscillating amplitude, for example, by using principles of the lever.

As for the intensity of magnetic field, about 6 x 10⁻⁹ emu of sensitivity with 0.3 Tesla have been obtained in the present embodiment (see Figs. 3 and 4), so that when a 10 Tesla magnetic field which is a feasible level is applied, the sensitivity may be enhanced by about 1000 times.

Although the one shot magnetic field has been applied in the present embodiment, it is possible to enlarge the oscillating amplitude by resonating the one shot magnetic field with the free oscillation period of the balance by synchronizing and by repeating it for a certain time period. Although the measuring resolution of the oscillation amplitude is 2 micrometers in the embodiment of the present invention, this may be improved relatively easily. Furthermore, in terms of the enlargement of the oscillating amplitude, it is possible to enlarge the oscillating amplitude of the specimen by elongating the beam on the counter balance side of the balance more than the beam on the specimen side by the ratio of length of both beams. By taking such means, the measuring sensitivity of the apparatus of the present invention may be enhanced to less than 10⁻¹² emu relatively easily. This sensitivity is higher than that of a SQUID (superconducting quantum interference device) method, which is conventionally considered to have the highest sensitivity, by 10 to 100 times. And the apparatus of the present invention does not require an extremely low temperature atmosphere for superconductivity like the SQUID method and allows to measure in very high sensitivity with a very simple structure.

As described above, the magnetic characteristics measuring apparatus of the present invention has such advantages that very high sensitive measurements may be realized with a very simple structure and without being influenced by magnetic noise caused by applied magnetic fields or any other background magnetic fields. The apparatus of the present invention only needs the pulsed electro-magnet that generates a one shot magnetic field, the dynamic oscillation system and the displacement detecting means, and simply measures the oscillating amplitude of the dynamic oscillation system after the extinction of the one shot magnetic field.

Furthermore, the apparatus of the present invention has other advantages in that magnetic characteristics of a substance having a magnetic anisotropy can be readily measured and that an influence of magnetic characteristics of the apparatus itself on the measured results may be eliminated.

## Claims

1. A magnetic characteristics measuring apparatus for measuring magnetic parameters of a specimen (1) comprising:
a magnetic field generating means (5) for applying a magnetic force to said specimen (1) only for a predetermined period of time;
a motion detecting means (2-4, 8-11) for detecting motion of said specimen (1) caused by said magnetic force applied;
wherein said motion detecting means includes a balancing mechanism (2-4) structured so that said specimen (1) dynamically keeps a balanced state and a displacement detecting means (8-11) for detecting displacement of said balancing mechanism (2-4) caused by said motion of said specimen (1),
**characterized in**
that a magnetic field detecting means (6, 7) is provided for detecting a magnetic field generated in a vicinity of said specimen (1),
that said magnetic parameters of said specimen (1) are found from a detected result of said magnetic field detecting means (6, 7) and a detected result of said motion detecting means (2-4, 8-11), wherein said detected result of said motion detecting means is a detected result of said balancing mechanism (2-4) in a free oscillating state after the application of a magnetic force by said magnetic field generating means (5) has been released.

2. The magnetic characteristic measuring apparatus according to claim 1, wherein said balancing mechanism (2-4) is provided with holders of said specimen (1) at at least two places and each holder is placed at positions (A, B) where they are symmetrical in a distribution of the magnetic field within said magnetc field generating means (5).

## Patentansprüche

1. Ein Gerät zum Messen magnetischer Eigenschaften, das die magnetischen Parameter einer Probe (1) mißt, beinhaltend:
ein Magnetfeldgenerierungsmittel (5) zum Anlegen einer Magnetkraft an die Probe (1) nur über einen vorgegebenen Zeitraum;
ein Bewegungserfassungsmittel (2-4, 8-11) zur Erfassung der Bewegung der Probe (1), bewirkt durch die angelegte Magnetkraft;
wobei das Bewegungserfassungsmittel einen Gleichgewichtsmechanismus (2-4), der so strukturiert ist, daß die Probe (1) dynamisch einen Gleichgewichtszustand beibehält, und ein Abweichungserfassungsmittel (8-11) zum Erfassen einer Abweichung des Gleichgewichtsmechanismus (2-4), verursacht durch die Bewegung der Probe (1), beinhaltet,
dadurch gekennzeichnet,
daß ein Magnetfelderfassungsmittel (6,7) zum Erfassen eines Magnetfelds vorgesehen ist, das in der Nähe der Probe (1) erzeugt wird,
daß die magnetischen Parameter der Probe (1) aus einem erfaßten Ergebnis des Magnetfelderfassungsmittels (6,7) und eines erfaßten Ergebnisses des Bewegungserfassungsmittels (2-4, 8-11) gefunden werden, wobei das erfaßte Ergebnis des Bewegungserfassungsmittels ein erfaßtes Ergebnis des Waagemechanismus (2-4) in einem frei schwingenden Zustand ist, nachdem die durch das Magnetfeldgenerierungsmittel (5) angelegte Magnetkraft abgeschaltet wurde.

2. Das Gerät zum Messen magnetischer Eigenschaften gemäß Anspruch 1, wobei das Ausgleichsmittel (2-4) an mindestens zwei Stellen mit Haltern für die Probe (1) versehen ist, und die Halter jeweils an Positionen (A, B) angeordnet sind, wo sie symmetrisch zur Magnetfeldverteilung innerhalb des Magnetfeldgenerierungsmittels (5) angeordnet sind.

## Revendications

1. Dispositif de mesure de caractéristiques magnétiques destiné à mesurer les paramètres magnétiques d'un spécimen (1) comprenant :
un moyen de génération de champ magnétique (5) destiné à appliquer une force magnétique audit spécimen (1) uniquement pendant un intervalle de temps prédéterminé,
un moyen de détection de mouvement (2-4, 8-11) destiné à détecter le mouvement dudit spécimen (1) provoqué par ladite force magnétique appliquée,
dans lequel ledit moyen de détection de mouvement comprend un mécanisme d'équilibrage (2-4) structuré de façon à ce que ledit spécimen (1) maintienne dynamiquement un état équilibré et un moyen de détection de déplacement (8-11) destiné à détecter le déplacement dudit mécanisme d'équilibrage (2-4) provoqué par ledit mouvement dudit spécimen (1),
**caractérisé en ce que**
un moyen de détection de champ magnétique (6, 7) est prévu pour détecter un champ magnétique généré au voisinage dudit spécimen (1),
lesdits paramètres magnétiques dudit spécimen (1) sont trouvés à partir d'un résultat détecté dudit moyen de détection de champ magnétique (6, 7) et un résultat détecté dudit moyen de détection de mouvement (2-4, 8-11), où ledit résultat détecté dudit moyen de détection de mouvement est un résultat détecté dudit mécanisme d'équilibrage (2-4) en état d'oscillation naturelle après que l'application d'une force magnétique par ledit moyen de génération de champ magnétique (5) a été arrêtée.

2. Dispositif de mesure de caractéristiques magnétiques selon la revendication 1, dans lequel ledit mécanisme d'équilibrage (2-4) est muni de dispositifs de maintien dudit spécimen (1) en au moins deux emplacements et chaque dispositif de maintien est placé à des positions (A, B) telles qu'elles sont symétriques dans une distribution du champ magnétique à l'intérieur dudit moyen de génération de champ magnétique (5).
